Europäisches Patentamt

European Patent Office

Office européen des brevets

(19)

(11) Veröffentlichungsnummer: **0 087 514**
**B1**

(12) **EUROPÄISCHE PATENTSCHRIFT**

(45) Veröffentlichungstag der Patentschrift:
09.04.86

(51) Int. Cl.⁴: **G 01 J 5/20**, G 01 J 5/34

(21) Anmeldenummer: 82111758.7

(22) Anmeldetag: 17.12.82

(54) Infrarotdetektor.

(30) Priorität: 29.01.82 DE 3202819

(43) Veröffentlichungstag der Anmeldung:
07.09.83 Patentblatt 83/36

(45) Bekanntmachung des Hinweises auf die Patenterteilung:
09.04.86 Patentblatt 86/15

(84) Benannte Vertragsstaaten:
FR GB

(73) Patentinhaber: PREH, Elektrofeinmechanische Werke Jakob Preh Nachf. GmbH & Co.,
Postfach 1740 Schweinfurter Strasse 5, D-8740 Bad Neustadt/Saale (DE)

(72) Erfinder: Schimmelpfennig, Wolfgang, Bergstrasse 26, D-8741 Schönau/Brend (DE)
Erfinder: Siede, Heinz-Jürgen, Dipl.-Ing., Altenbergstrasse 2, D-8740 Bad Neustadt/Saale (DE)

(56) Entgegenhaltungen:
US - A - 3 586 439

Chemical Abstracts Band 91, Nr. 10, 3. September 1979, Columbus, Ohio, USA, J. DUDONIS et al.:"The influence of ion bombardment during condensation on the properties of vacuum-deposited thin", Seite 484, Spalte 2
Chemical Abstracts Band 87, Nr. 10, 5. September 1977, Columbus, Ohio, USA, A.P. BRADFORD et al.: "The effect of the substrate temperature on the optical properties of reactively evaporated silicon oxide", Seite 519, Spalte 1

(56) Entgegenhaltungen: (Fortsetzung)
ELEKTRONIK, Band 28, Nr. 11, 1979, "Hochempfindliches Bolometer", Seite 11

Die Akte enthält technische Angaben, die nach dem Eingang der Anmeldung eingereicht wurden und die nicht in dieser Patentschrift enthalten sind.

## Beschreibung

Die Erfindung geht von einem Infrarotdetektor nach dem Oberbegriff des Anspruches 1 aus.

Für Strahlungs- und Temperaturmessungen werden zunehmend berührungslos arbeitende Detektoren benötigt. Diese Strahlungsempfänger (Detektoren) wandeln infrarote Strahlung in elektrische, optische oder mechanische Signale um. Man unterscheidet Nicht-Quantendetektoren (thermische Detektoren) und Quantendetektoren. Die Nicht-Quantendetektoren ändern aufgrund der Absorption infraroter Strahlung ihren inneren und/oder äußeren Energiezustand im Kristallgitter. Sie sprechen nicht auf Energiequanten an, sondern auf Strahlungsleistung. Die Quantendetektoren ändern aufgrund von Absorption infraroter Strahlung ihren elektronischen Zustand in atomaren Bereichen des Kristallgitters. Sie sprechen auf Energiequanten (Photonen) an. Man sagt, sie sind Quantenzähler.

Bei den Nicht-Quantendetektoren werden eine Reihe von physikalischen Effekten ausgenutzt, so z.B. der Seebeck-Effekt, der Bolometer-Effekt, der thermopneumatische Effekt, der Ettinghausen-Nernst-Effekt, der thermooptische Effekt und nicht zuletzt der pyroelektrische Effekt.

Detektoren, die den pyroelektrischen Effekt ausnutzen, sind erst in den letzten Jahren auf den Markt gekommen und sie haben sich wegen der Robustheit des Aufbaus und des einfachen Betriebes bereits einen ansehnlichen Marktanteil erobert. Diese Empfänger nutzen die Temperaturabhängigkeit der spontanen Polarisation sogenannter ferroelektrischer Kristalle oder Keramiken aus, die infolge ihres unsymmetrischen Kristallaufbaus einen Dipolcharakter und damit eine permanente elektrische Polarisation aufweisen. Der pyroelektrische Detektor ist im Prinzip ein strahlungsempfindlicher Kondensator. Eine Änderung der Temperatur infolge Strahlungsabsorption erzeugt eine Änderung der Polarisation, die wiederum eine Änderung der Potentialdifferenz am Kondensator zur Folge hat. Diese Potentialänderung kann mit einer geeigneten Verstärkerschaltung als Spannungs- oder Stromänderung gemessen werden. Da das Photosignal und das Rauschsignal sich mit zunehmender Modulationsfrequenz fast gleichmäßig ändern, bleibt das Nachweisvermögen (proportional dem Signal/Rauschverhältnis) über einen großen Frequenzbereich hinweg konstant. Als Materialien für pyroelektrische Detektoren werden vorwiegend TGS (Triglyzinsulfat), aber neuerdings auch Sinterkeramiken aus BSN (Barium-Strontiumniobat), PZT (Blei-Zirkon-Titanat) oder PLZT (Lanthandotiertes Blei-Zirkon-Titanat) verwendet.

Insbesondere für Strahlungsmessungen benötigen solche Detektorsysteme strahlungsabsorbierende Oberflächen, deren Herstellung auch wegen der erforderlichen Haftung auf Schwierigkeiten stößt. Die Strahlungsabsorption führt durch die daraus resultierende Erwärmung der Systeme zu den zur Strahlungsmessung ausgenutzten temperaturabhängigen physikalischen Effekten. Besonders für Anwendungen im infraroten Spektralbereich werden spezielle Absorptionsschichten benötigt, die eine über einen großen Wellenlängenbereich gleichmäßige Absorption zeigen. Für solche Absorptionsschichten gibt es mehrere Herstellungsverfahren.

Bekannt ist das Aufdampfen von sog. schwarzem Gold, einer Goldschicht, die in einem schlechten Vakuum aufgedampft wird und somit körnig ausfällt. Diese Schicht weist jedoch Nachteile in der Haftung auf. Neben der Verwendung des "Schwarzen Goldes" als infrarotabsorbierende Schicht kommen noch "Woltersdorff'sche Schichten" in Betracht, wie sie bereits 1934 in der Zeitschrift für Physik, Band 91, Seite 230 ff, beschrieben werden. Da die Herstellung dieser dünnen, im Bereich von $10^{-8}$ cm liegenden Metallschichten wegen der Oberflächenrauhigkeit des Trägermaterials und der immer noch vorhandenen Abhängigkeit der Absorption von der Wellenlänge Schwierigkeiten bereitet, ist für die Fertigung dieser infrarotabsorbierenden Schichten ein anderes Verfahren günstiger.

Eine Möglichkeit infrarot-absorbierende Schichten zu erhalten, wird von D.R. McKenszie, B. Window, G.L. Harding, A.R. Collins und D.W.J. Mackey im Journal of Vacuum Scientific Technology Band 19, S. 93 aus 1981 beschrieben. Danach werden in einer bestimmten Gasentladungs-Zerstäubungstechnik in einer Gasatmosphäre mit Acetylen-Anteil kohlenstoffhaltige Metallschichten abgeschieden. Dieses Verfahren hat jedoch den Nachteil, daß einerseits starke Verunreinigungen der Aufstäubeeinrichtungen mit kohlenstoffhaltigen Metallschichten auftreten, die schwierig zu entfernen sind, andererseits aber die elektrische Kontaktierung der Schichten mit haftfesten Anschlüssen (z.B. Drähten) schwierig ist, die besonders bei Systemen benötigt werden, die z.B. eine Kapazität als temperatur- bzw. strahlungsempfindliches System benutzen, wie etwa pyroelektrische Strahlungsdetektoren.

Aufgabe der vorliegenden Erfindung ist es, einen kostengünstig herstellbaren Infrarotdetektor nach dem Oberbegriff des Anspruches 1 zu finden, bei dem die oberste infrarotabsorbierende Schicht zu der darunterliegenden Schicht neben einer guten Haftfestigkeit auch eine gute Kontaktierbarkeit durch Kleben, Löten oder Schweißen aufweist.

Diese Aufgabe wird erfindungsgemäß durch die im kennzeichnenden Teil des Anspruches 1 angegebenen Merkmale gelöst.

Weitere vorteilhafte Ausgestaltungen der Erfindung sind den Unteransprüchen zu entnehmen.

Ein Ausführungsbeispiel der Erfindung wird nachfolgend anhand der Zeichnungen näher erläutert.

Von den Figuren zeigt

Figur 1 eine teilweise im Schnitt wiedergegebene perspektivische Darstellung eines Infrarotdetektors,

Figur 2 ein Schaltbild des Infrarotdetektors,

Figur 3 in Seitenansicht ein Detektorelement im Schnitt.

Der Infrarotdetektor besteht aus einem Gehäuse 1, in das ein Detektorelement 2 eingebaut ist. Das Gehäuse 1 selbst setzt sich aus einer Gehäusekappe 3 und einem Sockel 4 zusammen. Auf der Oberseite der Gehäusekappe ist eine Öffnung ausgespart, die von einem Fenster 5 abgedeckt ist, das für Infrarotstrahlung durchlässig ist. Auf der Unterseite des Gehäuses 1 ragen drei Anschlußstifte 6 heraus, von denen zwei Anschluß-stifte isoliert durch den Sockel durchgeführt sind und ein Anschluß-stift mit dem Sockel als Massenbezugspunkt verbunden ist.

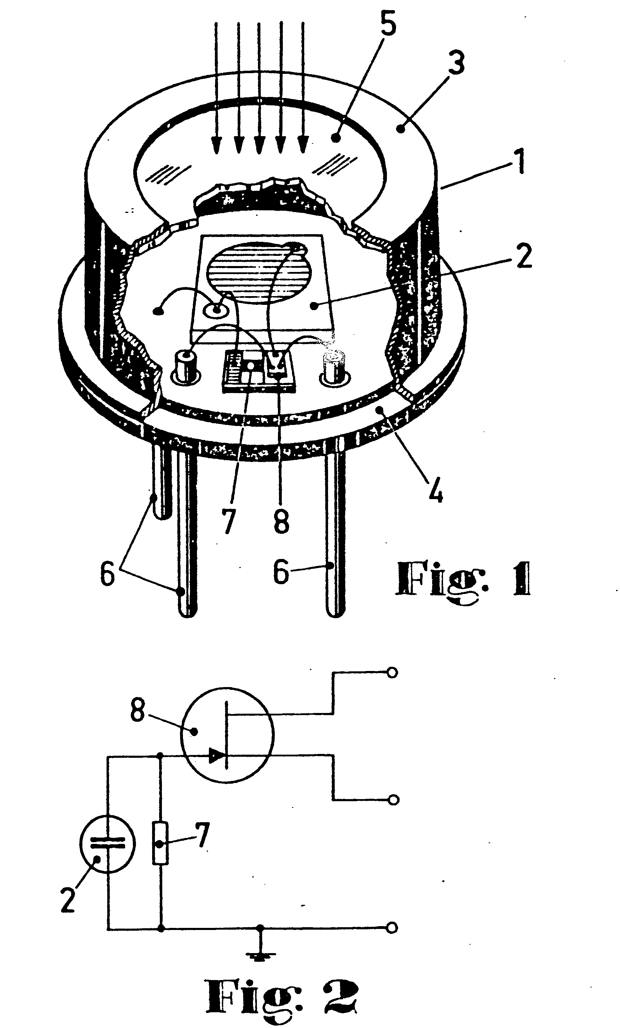

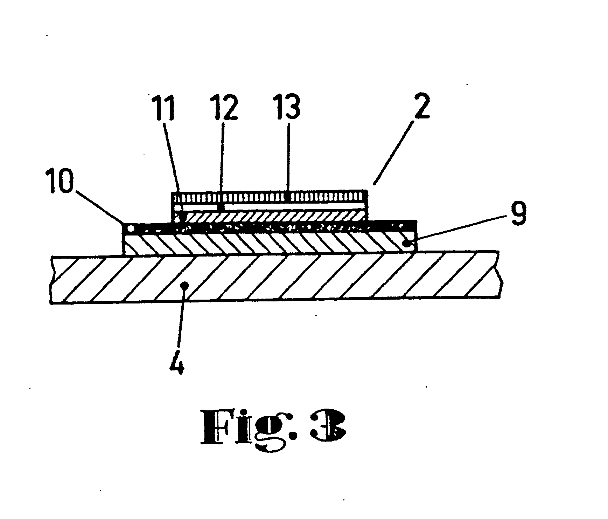

Im Inneren der Gehäusekappe befindet sich das eigentliche Detektorelement 2 und eine in Figur 2 dargestellte elektrische Schaltung. Parallel zum Detektorelement 2 ist ein Ableitwiderstand 7 geschaltet, dessen einer Anschluß an Masse und dessen anderer Anschluß mit dem Gateanschluß eines Feldeffekttransistors 8 verbunden ist. Der Drain- und der Source-anschluß sind getrennt zu den Anschlußstiften 6 geführt. Der dritte Anschlußstift ist -wie bereits erwähnt- mit der Masse des Gehäuses verbunden.

In Figur 3 ist das eigentliche Detektorelement mit seinem System von Mehrfachschichten im Schnitt dargestellt. Auf dem Gehäusesockel 4 ist eine wärmeisolierende Grundschicht 9 aufgebracht, die z.B. aus Aluminiumoxyd bestht, das auf den Sockel aufgeklebt ist. Über dieser Grundschicht 9 befindet isch eine Schicht 10 aus einem elektrisch leitfähigen Material, auf der der ein- oder beidseitig mit einer Grundelektrode 11 metallisierte pyroelektrische Kristall 12 aufgebracht ist. Die Schicht 10 und die Grundelektrode 11 können auch zu einer Schicht zusammengefaßt, sein falls es gelingt, den pyroelektrischen Kristall 12 direkt auf die elektrisch leitfähige Schicht 10 abzuscheiden. Als Material für die Schicht 10 kann man eine Metallfolie, wie z.B. eine Nickel- oder Aluminiumfolie, vorsehen. Abgedeckt wird der pyroelektrische Kristall 12 auf der Oberseite von einer infrarotabsorbierenden Schicht 13.

Nachfolgend soll das Verfahren beschrieben werden, wie diese infrarotabsorbierende Schicht 13 hergestellt werden kann. Das Aufbringen dieser Schicht kann grundsätzlich nach mehreren Verfahren z.B. Aufdampfen, Hochleistungszerstäuben oder Kathodenzerstäubung durchgeführt werden.

Vorzugsweise wird das bekannte Kathodenzerstäubungsverfahren angewendet. Dieses Verfahren ist vorteilhafter als das Aufdampfverfahren, denn es werden hier die im Plasma enthaltenen angeregten Ionen direkt zur Reaktion gebracht und nicht wie beim Verdampfen die kinetische Energie der Teilchen allein benutzt.

Zunächst wird bei dem reaktiven Kathodenzerstäubungsverfahren auf das strahlungs- bzw. temperaturempfindliche pyroelektrische Kristallsystem im Vakuum, auch nach vorheriger Maskierung der einzelnen Detektorelemente, falls diese zu mehreren gemeinsam in den vorhergehenden Arbeitsschritten hergestellt wurden, reaktiv in einer Argon/Sauerstoffatmosphäre eine schwarze Zinn-/Zinnoxydschicht aufgebracht. Mittels beschleunigter Edelgas-Ionen werden Metallatome von einer Kathode, dem sogenannten Target, herausgelöst, die dann auf dem Kristall kondensieren. Auf diese Weise wird eine Zinn-/Zinnoxydschicht, die nicht stöchiometrisch ist, in einer Dicke von vorzugsweise 4 µm auf die Kristalle aufgebracht. Während üblicherweise die Targets gekühlt oder leicht temperiert werden, wird hier das Target auf eine höhere Temperatur erhitzt, die vorzugsweise um den Schmelzpunkt liegt oder die sogar noch höher sein kann. Versuche haben gezeigt, daß besonders bei diesen Temperaturbedingungen die Verbindung zwischen Metall/Metalloxyde erhalten wird. Die reaktive Aufbringung des Zinns/Zinnoxyds erfolgt in einer Sauerstoff-Edelgasatmosphäre, wobei das Druckverhältnis Sauerstoff zu Edelgas 1: 50 bis 1: 200 beträgt. Als Partialdruck wurde für Sauerstoff $1,064 - 10^{-2}$ Pa und für Edelgas, z.B. Argon 1,064 Pa gewählt. Ist die gewünschte Schichtdicke durch Variation der Aufdampfzeit erreicht, erhält man eine schwarze, gut haftende, körnige Zinn-/Zinnoxydschicht mit einer Korngröße, die gleich oder größer als die Wellenlänge der absorbierenden Infrarot-Strahlung mit dem Bereich 1 - 20 µm ist. Die Schichtdicke soll so klein wie möglich sein, um die Wärmekapazität des Systems gering zu halten. Andererseits muß sie jedoch so dick sein, um in der Schicht noch eine ausreichende Strahlungsabsorption zu erhalten. Die IR-Absorption liegt, gemessen mit einem IR-Spektrometer, bei 70 % und die immer noch metallische Leitfähigkeit dieser Zinn-/Zinnoxydschicht macht sie geeignet für die Anwendung in kapazitiven Detektorsystemen, wie sie beispielsweise pyroelektrische Wärmestrahlungsdetektoren darstellen, die die Änderung der elektrischen Polarisation einer in einem Kondensatorsystem befindlichen Kristallschicht mit der Temperatur als physikalischen Effekt ausnutzen. Neben Zinn kann auch noch Silizium als Metall bzw. dessen Oxyd eingesetzt werden.

Die infrarotabsorbierende Schicht sollte eine verglichen mit der Wellenlänge der zu absorbierenden Strahlung vergleichbare oder größere Oberflächenrauhigkeit aufweisen. Von der Oberflächenrauhigkeit hängt nämlich die optische Reflexionsmöglichkeit der Schicht ab. Bei metallisch leitfähigen Schichten ist bei einer verglichen mit der Wellenlänge der optischen Strahlung kleineren Oberflächenrauhigkeit mit geometrischer Reflexion zu rechnen. Bei Erhöhung der Rauhigkeit geht die Reflexion in diffuse Streuung und schließlich in merkliche Absorption über.

In der Schicht sollte der nichtmetallische Anteil der Metallverbindung geringer sein als das stöchiometrische Gewichtsverhältnis. Hätte man ein stöchiometrisches Gewichtsverhältnis der Anteile Metall/Metalloxyde, so würde dies bedeuten, daß man mit einer relativ schlechten elektrischen Leitfähigkeit rechnen muß. Da aber die Schicht elektrisch gut leitend sein soll, muß der nichtmetallische Anteil geringer sein als das stöchiometrische Gewichtsverhältnis. Die gute elektrische Leitfähigkeit wird deshalb benötigt, weil die Schicht gleichzeitig eine Elektrode des pyroelektrischen Kondensatorsystems darstellt.

## Bezugszeichen zur Anmeldung "Infrarotdetektor"

1 Gehäuse
2 Detektorelement
3 Gehäusekappe
4 Gehäusesockel
5 Fenster in Gehäusekappe
6 Anschlußstifte
7 Ableitwiderstand
8 Feldeffekttransistor
9 Grundschicht
10 leitfähige Schicht
11 Grundelektrode
12 pyroelektrische Kristalle
13 infrarotabsorbierende Schicht

## Patentansprüche

1. Infrarotdetektor mit auf einem Träger (9) aufgebrachten System von Mehrfachschichten, wovon die oberste Schicht (13) eine im Vakuum durch thermische Verdampfung reaktiv oder durch reaktive Zerstäubung in einer Sauerstoff-Edelgasatmosphäre aufgebrachte, dünne und infrarotabsorbierende Schicht ist,
dadurch gekennzeichnet,
daß diese Schicht (13) aus einer chemisch beständigen, elektrisch leitfähigen Verbindung von einem Metall und dessen Oxyd besteht, und ihre Oberflächenstruktur rauh und körnig ist, wobei die Oberflächenstruktur eine verglichen mit der Wellenlänge der zu absorbierenden Strahlung vergleichbare oder größere Rauhigkeit zeigt.

2. Infrarotdetektor nach Anspruch 1,
dadurch gekennzeichnet,
daß in der Schicht (13) der nichtmetallische Anteil der Verbindung geringer ist als das stöchiometrische Gewichtsverhältnis.

3. Infrarotdetektor nach Anspruch 1 und 2,
dadurch gekennzeichnet,
daß Zuleitungen durch Löten, Kleben oder Schweißen an der Schicht (13) befestigt sind.

4. Infrarotdetektor nach Anspruch 1,
dadurch gekennzeichnet,
daß ein Metall verwendet wird, das während der reaktiven Zerstäubung bis zur Verflüssigung erhitzt wird.

## Claims

1. Infra-red detector with a system of multiple layers applied on a carrier (9), of which the uppermost layer (13) is a thin and infra-red-absorbent layer applied reactively in vacuum by thermal vaporisation or by reactive atomisation in an oxygen-noble gas atmosphere, characterised in that this layer (13) comprises a chemically stable, electrically conductive compound of a metal and its oxide, and its surface structure is rough and granular, wherein the surface structure shows a roughness comparable with or greater than the wave length of the radiation to be absorbed.

2. Infra-red detector according to claim 1, characterised in that in the layer (13) the non-metallic part of the compound is less than the stoichiometric weight ratio.

3. Infra-red detector according to claim 1 and 2, characterised in that supply lines are secured by soldering, adhesion or welding on the layer (13).

4. Infra-red detector according to claim 1, characterised in that a metal is used which is heated during the reactive absorption until it is liquefied.

## Revendications

1. Détecteur d'infrarouges muni d'un système à couches multiplesdéposéessur un substrat (9), la couche (13) occupant la position la plus haute étant une couche mince, absorbant les infrarouges et déposée réactivement sous vide par métallisation thermique ou par atomisation réactive dans une atmosphère d'oxygène/gaz rare, détecteur caractérisé par le fait que cette couche (13) consiste en un composé chimiquement résistant et électriquement conducteur d'un métal et d'un oxyde de ce métal, sa structure superficielle étant rugueuse et granulaire, cette structure superficielle présentant une rugosité comparable ou supérieure par comparaison avec la longueur d'onde du rayonnement devant être absorbé.

2. Détecteur d'infrarouges selon la revendication 1, caractérisé par le fait que, dans la couche (13) la proportion du ou des éléments non métalliques du composé est moindre que le rapport pondéral stoechiométrique.

3. Détecteur d'infrarouge selon les revendications 1 et 2, caractérisé par le fait que les conducteurs d'alimentation sont fixés à la couche (13) par brasage, collage ou soudage.

4. Détecteur d'infrarouges selon la revendication 1, caractérisé par le fait qu'on utilise un métal qui, au cours de l'atomisation réactive, est chauffé jusqu'à son passage à l'état liquide.

**Fig. 1**

**Fig. 2**

**Fig. 3**